# EUROPEAN PATENT APPLICATION

(11) **EP 3 316 387 A1**
(43) Date of publication of application: **02.05.2018**
(21) Application number: 16814022.6
(22) Date of filing: 01.04.2016
(51) Int. Cl.: H01M 10/42, G01R 31/36, H01M 10/48, H02J 7/00, B60L 3/00

(54) **ENERGY STORAGE SYSTEM**

(30) Priority: 25.06.2015 JP 2015127206
(71) Applicant: Hitachi, Ltd., Tokyo 100-8280 (JP)
(72) Inventor: KAMIJOH Takashi, Tokyo 100-8280 (JP)
(74) Representative: Beetz & Partner mbB
(86) International application number: PCT/JP2016/060877
(87) International publication number: WO 2016/208251

(57) **Abstract**

The invention is intended to improve the prediction accuracy of battery deterioration. An energy storage system includes a storage cell; a battery usage history detection unit that detects a usage history of the storage cell; an operation mode classification unit that classifies an operation mode of the storage cell according to the usage history of the storage cell; an SOH estimation unit that estimates a deterioration index value of the storage cell according to the usage history of the storage cell; and a remaining-service-life estimation unit that calculates a remaining service life of the storage cell according to the usage history of the operation mode of the storage cell, and the deterioration index value of the storage cell. The usage history of the storage cell represents a current value of the storage cell, a battery temperature of the storage cell, and a battery voltage of the storage cell.

## Description

### Technical Field

The present invention relates to an energy storage system.

### Background Art

In this age of growing environmental awareness, there has been an increasing market of energy storage systems using lithium-ion batteries. A lithium-ion battery deteriorates with system operation, and diagnosis of remaining service life is an important component of lithium-ion batteries. PTL 1 reports a technique for diagnosing remaining service life in an on-board energy storage system for automobiles. In this technique, the remaining service life is diagnosed from changes in the fuel consumption of classified driving modes from a drive measurement unit. A lithium-ion battery is known to deteriorate in a manner that depends on ambient environmental conditions. From this characteristic of lithium-ion batteries, PTL 2 reports a technique for diagnosing remaining service life in an on-board energy storage system for automobiles, whereby the proportion of each classified driving mode from a drive measurement unit is calculated, and the remaining service life is diagnosed by using the pre-measured result for each driving mode in a life database.

### Citation List

### Patent Literature

PTL 1: JP-A-2007-215332
PTL 2: JP-A-2008-126788

### Summary of Invention

### Technical Problem

Deterioration of lithium-ion batteries is heavily dependent on use conditions, for example, such as current value, voltage, and temperature. The feature of the techniques disclosed in PTL 1 and PTL 2 lies in the diagnosis of remaining service life using data related to different driving modes of an automobile. However, because battery deterioration depends on the conditions of the environment where the battery is used, and other factors such as temperature, current value, and the state of charge of the battery, it would not be possible with the techniques of PTL 1 and PTL 2 to detect detailed information of the battery state, and the accuracy of deterioration prediction will probably be poor. It is accordingly an object of the present invention to improve the prediction accuracy of battery deterioration.

### Solution to Problem

A feature of the present invention for solving the foregoing problem is, for example, as follows.

An energy storage system comprising: a storage cell; a battery usage history detection unit that detects a usage history of the storage cell; an operation mode classification unit that classifies an operation mode of the storage cell according to the usage history of the storage cell; an SOH estimation unit that estimates a deterioration index value of the storage cell according to the usage history of the storage cell; and a remaining-service-life estimation unit that calculates a remaining service life of the storage cell according to the usage history of the operation mode of the storage cell, and the deterioration index value of the storage cell.

An energy storage system in which the usage history of the storage cell represents a current value of the storage cell, a battery temperature of the storage cell, and a battery voltage of the storage cell.

An energy storage system in which the operation mode classification unit classifies an operation mode of the storage cell according to ranges of at least two characteristic values selected from a current value of the storage cell, a battery temperature of the storage cell, and an SOC of the storage cell calculated from a battery voltage of the storage cell.

An energy storage system in which the operation mode classification unit calculates a characteristic value of the usage history of the storage cell for each operation mode classified by the operation mode classification unit.

An energy storage system in which the remaining-service-life estimation unit calculates a remaining service life of the storage cell according to a deterioration prediction formula for each operation mode of the storage cell, and the deterioration index value of the storage cell.

An energy storage system comprising: a storage cell; a battery usage history detection unit that detects a usage history of the storage cell; an operation mode classification unit that classifies an operation mode of the storage cell according to the usage history of the storage cell; and an SOH estimation unit that estimates a deterioration index value of the storage cell according to the usage history of the storage cell, wherein the energy storage system receives a remaining service life of the storage cell calculated in a cloud server according to the usage history of the operation mode of the storage cell, and the deterioration index value of the storage cell.

An energy storage system in which a deterioration prediction formula of the storage cell is updated according to the extent by which a predicted value calculated by the cloud server for the battery deterioration index of the storage cell deviates from a predicted value recorded in the cloud server for the battery deterioration index of the storage cell.

### Advantageous Effects of Invention

The present invention can improve the prediction accuracy of battery deterioration. Other objects, configurations, and advantages will be apparent from the descriptions of the embodiment below.

### Brief Description of Drawings

[FIG. 1] FIG. 1 is a diagram representing an output process for the result of a diagnosis of the remaining service life of a lithium-ion battery according to an embodiment of the present invention.
[FIG. 2] FIG. 2 represents a characteristic diagram of the relationship between the use condition of the lithium-ion battery, and lithium-ion battery deterioration according to the embodiment of the present invention.
[FIG. 3] FIG. 3 represents an example of a table classifying the operation mode using two kinds of battery usage histories according to the embodiment of the present invention.
[FIG. 4] FIG. 4 represents tables showing the reference thresholds used to classify the operation mode using three kinds of battery usage histories according to the embodiment of the present invention.
[FIG. 5] FIG. 5 shows an example of a table in which the operation mode is classified using three kinds of battery usage histories according to the embodiment of the present invention.
[FIG. 6] FIG. 6 is a diagram representing an output process for the result of a diagnosis of the remaining service life of a lithium-ion battery according to the embodiment of the present invention.
[FIG. 7] FIG. 7 is a diagram representing an output process for the result of a diagnosis of the remaining service life of a lithium-ion battery according to the embodiment of the present invention.
[FIG. 8] FIG. 8 represents the procedure for diagnosing the remaining service life of a lithium-ion battery, and outputting the result according to the embodiment of the present invention.

### Description of Embodiments

The following specifically describes an embodiment of the present invention with reference to the accompanying drawings. The following detailed explanation serves to illustrate or describe specific examples of the substance of the present invention, and does not limit the invention in any ways. Various changes and modifications may be appropriately made by a skilled person without departing from the technical idea disclosed herein. In all drawings describing the present invention, the same reference numerals may be used to refer to the functionally same members, and descriptions of such members may be omitted to avoid redundancy.

The control method and computer programs of the present invention will be described in a series of procedures. However, the order of the procedures described below is not intended to limit the order in which these procedures can be executed. When implementing the control method and computer programs of the present invention, the order of the procedures may therefore be varied, as long as it does not interfere with the substance of the present invention.

The procedures of the control method and computer programs of the present invention do not need to be executed at different times. That is, the procedures may be executed such that, for example, a part of the procedures may occur while some other procedure is being executed, or different procedures may be executed at the same time, either in part or as a whole.

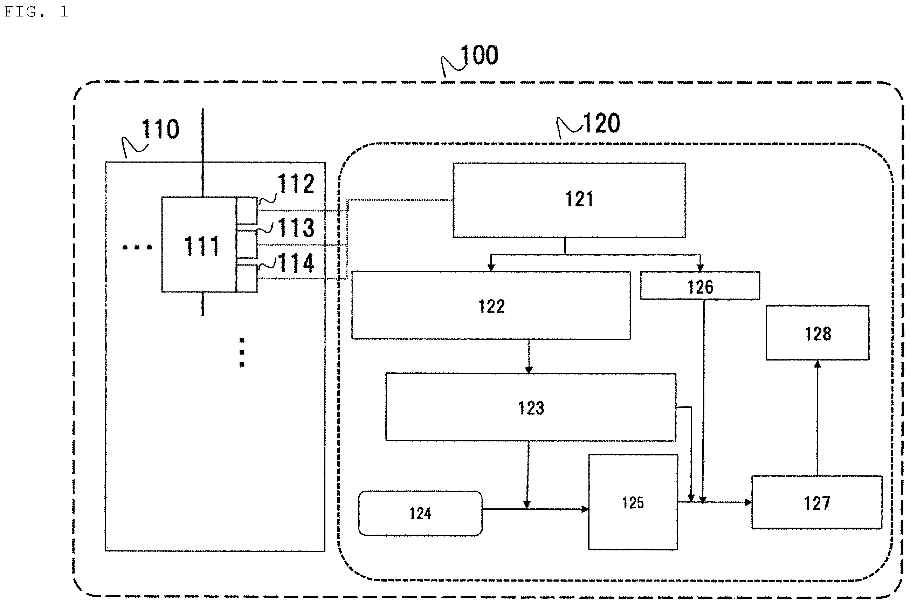

FIG. 1 is a diagram representing an output process for the result of a diagnosis of the remaining service life of a lithium-ion battery according to the embodiment of the present invention.

An energy storage system (lithium-ion battery system) 100 is configured from a battery pack 110, and a battery life output section 120.

The battery pack 110 is configured from series-parallel storage cells, such lithium-ion batteries 111, and a current measurement unit 112, a voltage measurement unit 113, and a battery temperature measurement unit 114 provided alongside the lithium-ion batteries 111, and that measure the current value, the voltage value, and the temperature of the lithium-ion batteries 111.

The battery life output section 120 is configured from a battery usage history detection unit 121, an operation mode classification unit 122, a characteristic value aggregation unit 123, a deterioration prediction formula storage unit 124, a deterioration prediction formula calculation unit 125, an SOH estimation unit 126, a remaining-service-life estimation unit 127, and a display section 128. The battery life output section 120 includes a CPU (Central Processing Unit), a RAM (Random Access Memory), a ROM (Read Only Memory), and peripheral circuits. For example, system components, such as the operation mode classification unit 122, and the characteristic value aggregation unit 123 may be stored in the ROM, and may be executed by the CPU using the RAM.

The battery usage history detection unit 121 has a means to communicate with the current measurement unit 112, the voltage measurement unit 113, and the battery temperature measurement unit 114, and functions to detect the usage history (battery usage history) of the current value, the voltage value, and the battery temperature of the lithium-ion battery 111. The detected usage history of current value, voltage value, and battery temperature is used for classification of operation modes (described later), and for calculations performed in the diagnosis of remaining service life. The characteristic values extracted from the battery usage history detection unit 121 are output to the operation mode classification unit 122.

In the operation mode classification unit 122, the charged state of the lithium-ion battery, and an SOC are estimated from the current value, the voltage value, and the battery temperature of the lithium-ion battery. In the operation mode classification unit 122, the lithium-ion battery 111 is classified by operation mode.

As used herein, "operation mode" refers to a mode that is classified according to various operational states of a battery in an environment in which the battery is used. The lithium-ion battery 111 is classified into different operation modes according to the parameter values detected in the battery usage history detection unit 121, including, for example, current value, battery temperature, and SOC. The classification method will be described later.

In the operation mode classification unit 122, a characteristic value is calculated for the characteristic value of the parameter value of each operation mode at regular intervals, for example, every 12 hours or 24 hours. Examples of the characteristic value include average current value, effective current value, average temperature, and average SOC. Average current value, effective current value, average temperature, and average SOC are selected as characteristic values because these values have large impact on deterioration of the lithium-ion battery 111, and using the mean values of these battery usage histories improves the diagnosis accuracy of remaining service life. The characteristic values, including average current value, effective current value, average temperature, and average SOC, calculated in the operation mode classification unit 122 are regularly output to the characteristic value characteristic value aggregation unit 123 on a regular basis.

In the characteristic value aggregation unit 123, each average characteristic value calculated for different operation modes from the start of system operation is regularly updated. The updated average characteristic value for each operation mode is used for calculations in the diagnosis of remaining service life (described later). By regularly updating the value, more accurate information can be obtained for battery usage history, and the diagnosis accuracy of remaining service life improves. The deterioration state of the lithium-ion battery 111 can be estimated with improved accuracy, and the diagnosis accuracy of remaining service life improves when a deterioration prediction formula, customized for each operation mode, is used in combination. The characteristic value aggregation unit 123 also functions to calculate an operation rate from the past operation time of the operation mode, in addition to the average characteristic value, and store the result of calculation.

The deterioration prediction formula storage unit 124 stores the deterioration prediction formula constructed from the result of a previously conducted battery test.

In the deterioration prediction formula calculation unit 125, the deterioration prediction formula for each operation mode is regularly updated using the prediction formula stored in the deterioration prediction formula storage unit 124, and the characteristic value regularly updated for each operation mode in the characteristic value aggregation unit 123. The prediction formula stored in the deterioration prediction formula storage unit 124 is configured to accept parameter values so that the formula is completed upon inputting the average current value, the effective current value, the average temperature, the average SOC, and other parameter values calculated in the characteristic value aggregation unit 123. The updated deterioration prediction formula for each operation mode is used in calculations for the diagnosis of the remaining service life of the lithium-ion battery 111. By also using the deterioration prediction formula customized for each operation mode, the deterioration state of the lithium-ion battery 111 can be estimated with improved accuracy, and the diagnosis accuracy of remaining service life improves.

The SOH estimation unit 126 estimates the state of battery deterioration, or SOH, from the current value, the voltage value, and the battery temperature. Specifically, the deterioration index value of the lithium-ion battery 111 is estimated. A battery's SOH is 100% when the battery capacity or battery resistance is at its initial value, and SOH is used as an index of the extent of battery deterioration.

The remaining-service-life estimation unit 127 estimates the remaining service life of the lithium-ion battery 111. The remaining service life of the lithium-ion battery 111 is diagnosed by using the deterioration prediction formula for each operation mode regularly updated in the deterioration prediction formula calculation unit 125, the operation rate of each operation mode calculated in the characteristic value aggregation unit 123, and the SOH calculated in the SOH estimation unit 126. By using the deterioration prediction formula and the operation rate of each operation mode, changes in the deterioration of the lithium-ion battery 111 can be estimated with improved accuracy, and the diagnosis accuracy of remaining service life improves. The diagnosis accuracy of remaining service life further improves with the use of the current SOH, and the estimated change in the deterioration of the lithium-ion battery 111.

The display section 128 displays information, for example, the diagnosis result for the remaining service life of the lithium-ion battery 111, on a screen, according to the result from the remaining-service-life estimation unit 127. The result sent to the display section 128 may be the calculated remaining service life, or advice concerning operation of the lithium-ion battery 111. The remaining service life of the lithium-ion battery 111 is diagnosed with the configurations described above.

The following describes the technique used to classify the operation mode in the operation mode classification unit 122 of the battery life output section 120. The relationship between the use condition of a battery, and battery deterioration is described first.

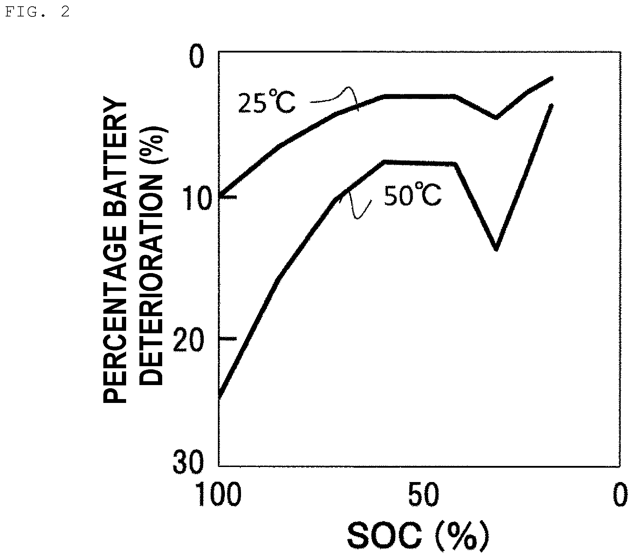

FIG. 2 is a characteristic diagram representing how the SOC of a lithium-ion battery, and the lithium-ion battery temperature are related to deterioration of the lithium-ion battery. Specifically, FIG. 2 represents an example of a characteristic diagram of the relationship between the use condition of a lithium-ion battery, and deterioration of the lithium-ion battery. The characteristic diagram is based on the calculations of the deterioration of the lithium-ion battery 111 when the lithium-ion battery 111 at different SOC levels is stored at different temperatures. In the example of FIG. 2, the percentage deterioration of lithium-ion battery capacity as an index of deterioration of the lithium-ion battery 111 is shown for temperatures of 25°C and 50°C. The horizontal axis represents SOC, and the vertical axis represents the percentage capacity deterioration of the lithium-ion battery 111.

It can be seen from FIG. 2 that the deterioration of the lithium-ion battery 111 is dependent on the temperature and the SOC of the lithium-ion battery 111. The temperature and the SOC of the lithium-ion battery 111 are expected to fluctuate during the operation. The accurate temperature and SOC values of the lithium-ion battery 111 cannot be found when the calculated values are the mean temperature and SOC of the lithium-ion battery 111 throughout its operation. Without the accurate values, accuracy cannot be expected for the values input to the deterioration prediction formula storage unit 124 of the battery life output section 120, and the remaining service life of the lithium-ion battery 111 cannot be diagnosed with accuracy. To avoid this, the operation mode is classified by setting thresholds for environmental conditions, such as the temperature and the SOC of the lithium-ion battery 111.

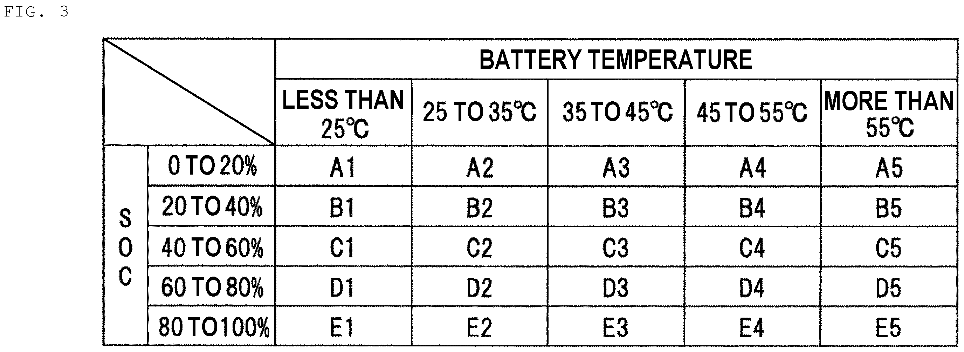

FIG. 3 represents an example of a table classifying the operation mode. In FIG. 3, the operation mode is classified into 25 operation modes, A1 to E5, according to the values of SOC and battery temperature. In this exemplary method, the classification is based on the SOC and the battery temperature of a lithium-ion battery. However, the operation mode may be classified according to a combination of SOC and current value, or a combination of battery temperature and current value. It is also possible to combine SOC, battery temperature, and current value. Battery life is diagnosed using the characteristic values of each operation mode so classified. In other words, the prediction accuracy for the life of the lithium-ion battery 111 improves when the operation mode classification unit 122 classifies the operation mode of the lithium-ion battery 111 according to ranges of at least two characteristic values selected from the current value of the lithium-ion battery 111, the battery temperature of the lithium-ion battery 111, and the SOC of the lithium-ion battery 111 calculated according to the battery voltage of the lithium-ion battery 111.

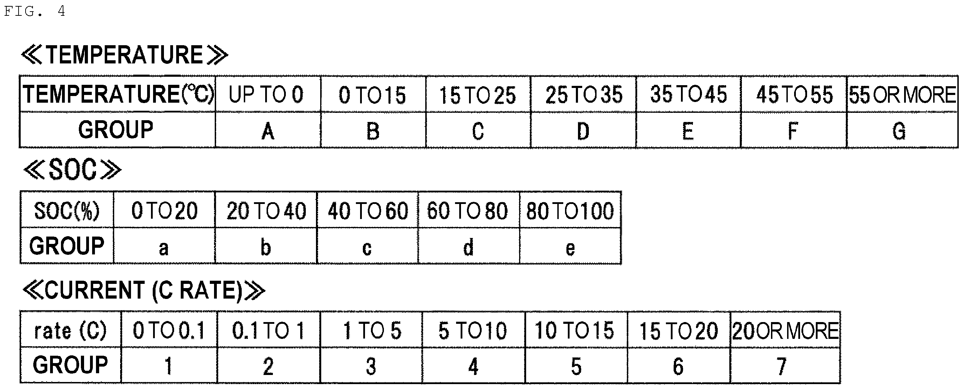

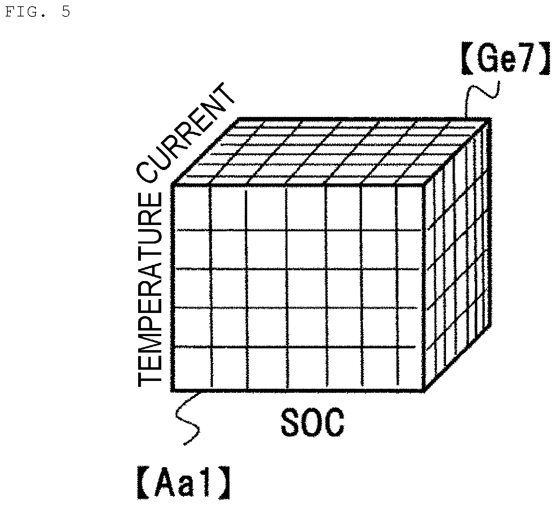

For example, with 7 levels of operation modes based on battery temperature, 5 levels of operation modes based on SOC, and 7 levels of operation modes based on current (C rate) as shown in FIG. 4, the operation mode can be classified into a total of 245 operation modes as in the three-dimensional matrix shown in FIG. 5. FIG. 4 represents tables showing the reference thresholds used to classify the operation mode using three kinds of battery usage histories. FIG. 5 shows an example in which the operation mode is classified using three kinds of battery usage histories.

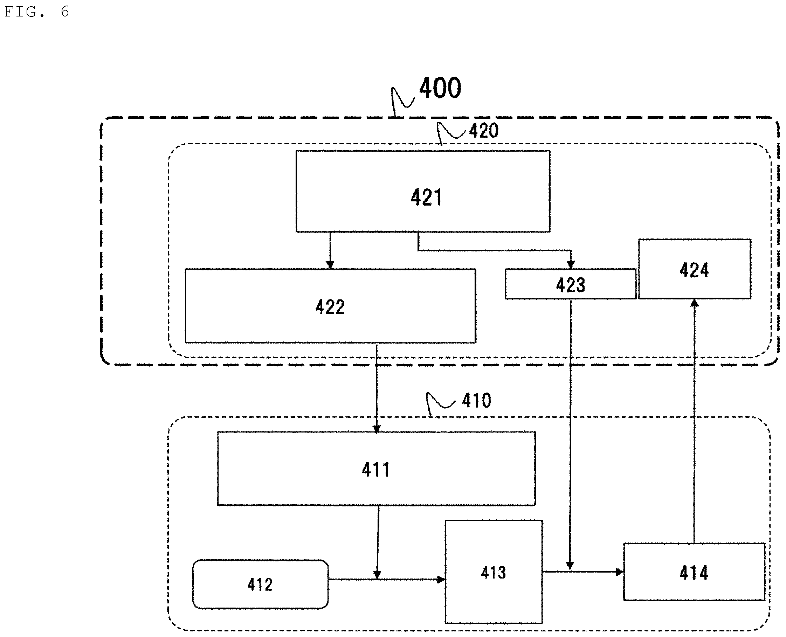

FIG. 6 is a diagram representing an output process for the result of a diagnosis of the remaining service life of a lithium-ion battery according to another embodiment of the present invention. FIG. 4 is characterized in the use of a cloud server 410. With the cloud server 410 taking a part of the calculation system for the diagnosis of remaining service life, it is possible to reduce the size of an energy storage system 400. The energy storage system 400 is configured so that a battery life output section 420 includes a battery usage history detection unit 421, an operation mode classification unit 422, an SOH estimation unit 423, and a display section 424. The battery life output section 420 includes a CPU (Central Processing Unit), a RAM (Random Access Memory), a ROM (Read Only Memory), and peripheral circuits. For example, system components, such as the battery usage history detection unit 421, and the operation mode classification unit 422 may be stored in the ROM, and may be executed by the CPU using the RAM. The cloud server 410 is configured from a characteristic value aggregation unit 411, a deterioration prediction formula storage unit 412, a deterioration prediction formula calculation unit 413, and a remaining-service-life estimation unit 414.

The battery usage history detection unit 421 functions to detect, for example, the current value, the voltage value, and the battery temperature of the lithium-ion battery. The characteristic values extracted from the battery usage history detection unit 421 are output to the operation mode classification unit 422.

In the operation mode classification unit 422, the charged state of the lithium-ion battery, or SOC, is estimated from the current value, the voltage value, and the battery temperature of the lithium-ion battery. In the operation mode classification unit 422, the lithium-ion battery is classified by operation mode. In the operation mode classification unit 422, the operation mode is classified according to the current value, the battery temperature, the SOC, and other parameter values of the lithium-ion battery detected in the battery usage history detection unit 421. In the operation mode classification unit 422, a characteristic value is calculated for the parameter value (battery usage history) of each operation mode at regular intervals, such as every 12 hours or 24 hours. Examples of the characteristic value include average current value, effective current value, average temperature, and average SOC. The characteristic values, including average current value, effective current value, average temperature, and average SOC, calculated in the operation mode classification unit 422 are output to the characteristic value aggregation unit 411 of the cloud server 410 on a regular basis. In this way, more accurate information can be obtained for the usage history of the lithium-ion battery 111, and the diagnosis accuracy of remaining service life of the lithium-ion battery 111 improves.

In the characteristic value aggregation unit 411, each average characteristic value calculated for each operation mode from the start of system operation is regularly updated. The characteristic value aggregation unit 411 also functions to calculate an operation rate from the past operation time of the operation mode, in addition to the average characteristic value, and store the result of calculation.

The deterioration prediction formula storage unit 412 stores the prediction formula constructed from the result of a battery test previously conducted for the lithium-ion battery.

In the deterioration prediction formula calculation unit 413, the deterioration prediction formula of the lithium-ion battery for each operation mode is regularly updated using the prediction formula stored in the deterioration prediction formula storage unit 412, and the characteristic value of each operation mode regularly updated in the characteristic value aggregation unit 411. The prediction formula stored in the deterioration prediction formula storage unit 412 is configured to accept parameter values so that the formula is completed upon inputting the average current value, the effective current value, the average temperature, the average SOC, or other parameter values calculated in the characteristic value aggregation unit 411.

The SOH estimation unit 423 estimates the state of battery deterioration, or SOH, from the current value, the voltage value, and the battery temperature of the lithium-ion battery. The SOH is also sent to the cloud server 410 on a regular basis.

The remaining-service-life estimation unit 414 estimates the remaining service life of the lithium-ion battery. The remaining service life of the lithium-ion battery is diagnosed by using the deterioration prediction formula regularly updated for each operation mode in the deterioration prediction formula calculation unit 413, the operation rate of each operation mode calculated in the characteristic value aggregation unit 411, and the SOH.

The diagnosis result for the remaining service life of the lithium-ion battery is sent to the battery life output section 420, and the display section 424 outputs the result.

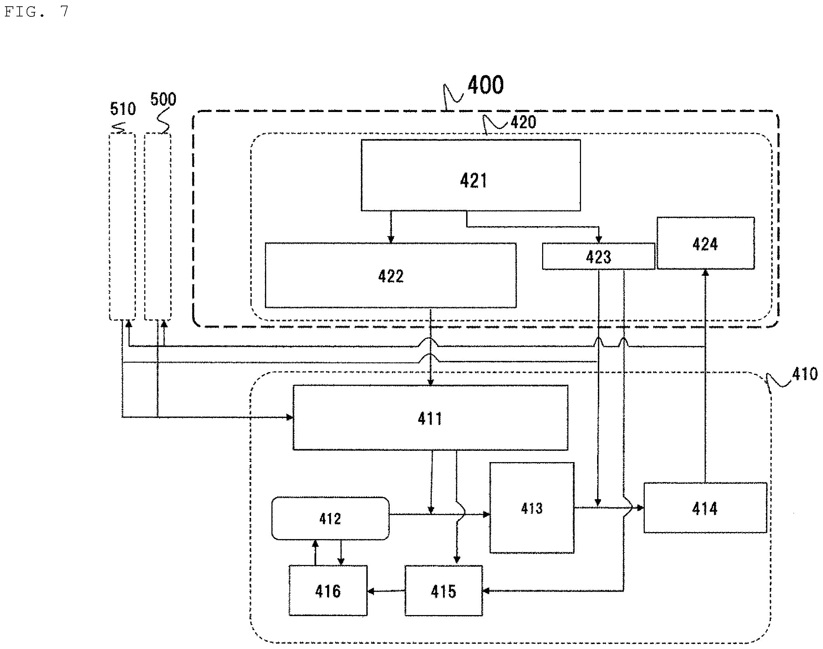

FIG. 7 represents an embodiment in which multiple energy storage systems, which include such as a second energy storage system 500, and a third energy storage system 510, are used in the embodiment of FIG. 6.

The characteristic value aggregation unit 411 of the cloud server 410 regularly updates characteristic values, specifically, the average current value, the effective current value, the average temperature, and the average SOC for each operation mode of each energy storage system, using data sent from the operation mode classification units of the multiple energy storage systems, which include the energy storage system 400, and the second energy storage system 500 and the third energy storage system 510. The characteristic value aggregation unit 411 calculates the operation rate of each operation mode for each energy storage system, in addition to the average characteristic value, and stores the result of calculation. The remaining service life of the lithium-ion battery of each energy storage system is diagnosed using the characteristic value of each operation mode regularly updated by the characteristic value aggregation unit 411 for each energy storage system, the deterioration prediction formula stored in the deterioration prediction formula storage unit 412, and the SOH sent from the SOH estimation unit of each energy storage system. The diagnosis result for the lithium-ion battery remaining service life is sent to the battery life output section of each energy storage system, and the display section outputs the result.

A feature of the embodiment represented in FIG. 5 is that the deterioration prediction formula is regularly updated by assessing the validity of the deterioration prediction formula of lithium-ion battery stored in the deterioration prediction formula storage unit 412 of the cloud server 410, using information from different energy storage systems, including the second energy storage system 500 and the third energy storage system 510. The following describes how the prediction formula is updated.

The characteristic values of each energy storage system, including the average current value, the effective current value, the average temperature, and the average SOC, aggregated for each operation mode by the characteristic value aggregation unit 411 of the cloud server 410 are regularly sent to a deterioration prediction formula storage unit 415 for cloud server, and stored therein. The characteristic values may be stored at any intervals, for example, every day, every month, or every 6 months. However, from the standpoint of usefulness of data, and data storage capacity, the storage interval is preferably every month or a similar interval, because it is desirable to have larger numbers of data for update of prediction formula. The SOH sent from the SOH estimation unit of each energy storage system is regularly sent to the deterioration prediction formula storage unit 415 for cloud server, and stored therein. The SOH may be stored at any intervals, and is stored preferably every month or at similar intervals for the same reason described for the characteristic values. The following description will be given through the case where the storage interval is every month.

The average characteristic values for each operation mode of each energy storage system stored in the deterioration prediction formula storage unit 415 for cloud server, and the SOH of each energy storage system are regularly sent to an SOH verification unit 416. The SOH verification unit 416 assesses the validity of the deterioration prediction formula of lithium-ion battery stored in the deterioration prediction formula storage unit 412. In the SOH verification unit 416, a monthly estimate of SOH is calculated for each energy storage system using the deterioration prediction formula stored in the deterioration prediction formula storage unit 412, and the average characteristic values for each operation mode of each energy storage system, and the validity of the estimated value is assessed by comparing it with the SOH value actually measured every month for each energy storage system and sent from the deterioration prediction formula storage unit 415 for cloud server. When the SOH verification unit 416 determines that the estimated SOH value for each energy storage system deviates from the measured SOH value by an error of, for example, 10% or more, the system determines that the prediction formula needs an update, and the update process is started. In the update process, a process that optimizes the coefficient of the input-type deterioration prediction formula stored in the deterioration prediction formula storage unit 412 of the cloud server 410 is performed so that the error between the estimated SOH value and the measured SOH value becomes less than 10%. The deterioration prediction formula in the deterioration prediction formula storage unit 412 may be updated at any intervals, for example, once in at least every 6 months, during which a relatively large data volume will be collected.

The accuracy of the deterioration prediction formula in the deterioration prediction formula storage unit 412, and therefore the diagnosis accuracy of the remaining service life of each energy storage system can improve by performing the foregoing steps of the embodiment of FIG. 7.

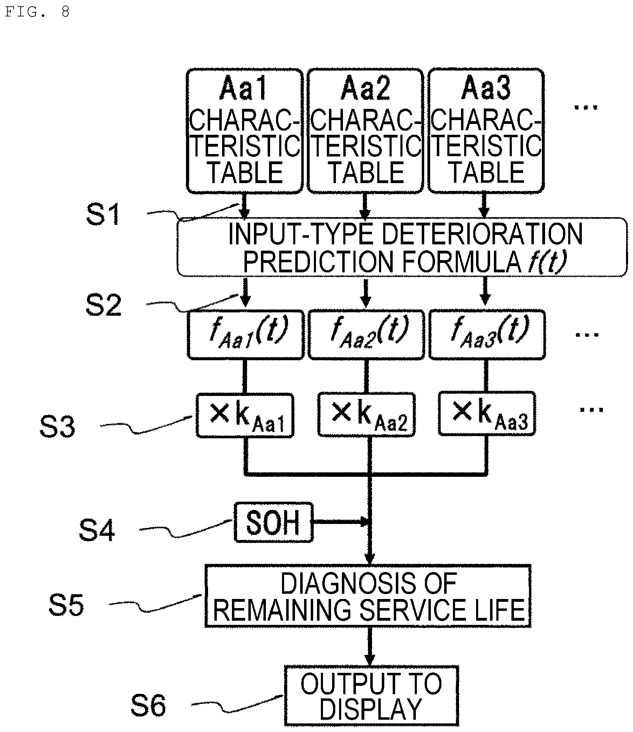

FIG. 8 represents the procedure for diagnosing the remaining service life of a lithium-ion battery according to different operation modes in an embodiment of the present invention.

### <Step S1>

The values of the characteristic table of each operation mode are input to the input-type prediction formula.

### <Step S2>

A prediction formula is constructed for each operation mode.

### <Step S3>

A coefficient is calculated from the operation rate of each operation mode, and combined with the deterioration prediction formula for each operation mode to construct a single complex formula.

### <Step S4>

An SOH is incorporated in the complex prediction formula.

### <Step S5>

The complex prediction formula and the SOH are used to diagnose remaining service life.

### <Step S6>

The diagnosis result for the remaining service life of the lithium-ion battery is output to the display. In addition to the remaining service life of the lithium-ion battery, advice related to use of lithium-ion battery is also displayed with a message, for example, "avoid hard breaking or hard acceleration while the temperature is low".

### Reference Signs List

100: Energy storage system
110: Battery pack
111: Lithium-ion battery
112: Current measurement unit
113: Voltage measurement unit
114: Battery temperature measurement unit
120: Battery life output section
121: Battery usage history detection unit
122: Operation mode classification unit
123: Characteristic value aggregation unit
124: Deterioration prediction formula storage unit
125: Deterioration prediction formula calculation unit
126: SOH (State of Health) estimation unit
127: Remaining-service-life estimation unit
128: Display section
400: Energy storage system
410: Cloud server
411: Characteristic value aggregation unit
412: Deterioration prediction formula storage unit
413: Deterioration prediction formula calculation unit
414: Remaining-service-life-estimation unit
415: Deterioration prediction formula storage unit for cloud server
416: SOH verification unit
420: Battery life output section
421: Battery usage history detection unit
422: Operation mode classification unit
423: SOH estimation unit
424: Display section
500: Second energy storage system
510: Third energy storage system

## Claims

1. An energy storage system comprising:
a storage cell;
a battery usage history detection unit that detects a usage history of the storage cell;
an operation mode classification unit that classifies an operation mode of the storage cell according to the usage history of the storage cell;
an SOH estimation unit that estimates a deterioration index value of the storage cell according to the usage history of the storage cell; and
a remaining-service-life estimation unit that calculates a remaining service life of the storage cell according to the usage history of the operation mode of the storage cell, and the deterioration index value of the storage cell.

2. The energy storage system according to claim 1, wherein the usage history of the storage cell represents a current value of the storage cell, a battery temperature of the storage cell, and a battery voltage of the storage cell.

3. The energy storage system according to claim 1, wherein the operation mode classification unit classifies an operation mode of the storage cell according to ranges of at least two characteristic values selected from a current value of the storage cell, a battery temperature of the storage cell, and an SOC of the storage cell calculated from a battery voltage of the storage cell.

4. The energy storage system according to claim 1, wherein the operation mode classification unit calculates a characteristic value of the usage history of the storage cell for each operation mode classified by the operation mode classification unit.

5. The energy storage system according to claim 1, wherein the remaining-service-life estimation unit calculates a remaining service life of the storage cell according to a deterioration prediction formula for each operation mode of the storage cell, and the deterioration index value of the storage cell.

6. An energy storage system comprising:
a storage cell;
a battery usage history detection unit that detects a usage history of the storage cell;
an operation mode classification unit that classifies an operation mode of the storage cell according to the usage history of the storage cell; and
an SOH estimation unit that estimates a deterioration index value of the storage cell according to the usage history of the storage cell,
wherein the energy storage system receives a remaining service life of the storage cell calculated in a cloud server according to the usage history of the operation mode of the storage cell, and the deterioration index value of the storage cell.

7. The energy storage system according to claim 6, wherein a deterioration prediction formula of the storage cell is updated according to the extent by which a predicted value calculated by the cloud server for the battery deterioration index of the storage cell deviates from a predicted value stored in the cloud server for the battery deterioration index of the storage cell.
